# EUROPEAN PATENT SPECIFICATION

(11) **EP 3 603 357 B1**
(45) Date of publication and mention of the grant of the patent: **31.03.2021**
(21) Application number: 18704479.7
(22) Date of filing: 01.02.2018
(51) Int. Cl.: H05K 5/00

(54) **TOOL-LESS COVER ASSEMBLY**
WERKZEUGLOSE ABDECKUNGSANORDNUNG
ENSEMBLE COUVERCLE SANS OUTIL

(30) Priority: 24.03.2017 DE 102017002839
(43) Date of publication of application: 05.02.2020
(73) Proprietor: Husqvarna AB, 561 82 Huskvarna (SE)
(72) Inventor: KLEY, Wolfgang, 88471 Laupheim (DE)
(74) Representative: Finkele, Rolf
(86) International application number: PCT/EP2018/052531
(87) International publication number: WO 2018/171966

(56) References cited:
- EP-A1- 2 273 581
- CN-Y- 2 750 622
- DE-A1-102013 203 195
- US-A- 4 431 113

## Description

### TECHNICAL FIELD

The present disclosure relates to a tool-less cover assembly, and more particularly to the tool-less cover assembly for a device, such as a valve control unit.

### BACKGROUND

Generally, electrical or electronic devices include a lid or a cover assembly to enclose an operator interface, power terminals, circuitry, and so on related to the devices. The devices may include handheld devices such as a remote controller; a wall mounted device such as a control unit of an automatic irrigation system, a home automation system; an indoor/outdoor equipment such as a vacuum cleaner, a pressure washer, a lawn mower, and so on. The cover assembly may provide desired access to internal components of the device. Also, in some situations, the cover assembly may prevent accidental contact with the internal components or controls of the device enclosed within the cover assembly. Also, the cover assembly may provide attractive aesthetics to the device by enclosing the internal components therein.

In many situations, the cover assembly may have to be disassembled from the device, such as during maintenance of the device, operation of one or more controls of the device, replacement due to damage, and so on. However, it may be difficult and time consuming for a user of the device to easily assemble/disassemble the cover assembly with respect to the device at all times, mainly due to requirement of dedicated tools, higher mounting forces, limited user knowledge, poor ergonomics, etc. In many situations, the cover assembly may be permanently damaged due to incorrect assembly/disassembly, poor design of mounting elements, limited visibility of mounting elements, limited user knowledge, wear and tear, etc.

CN2750622Y provides a battery cover for a portable electronic device. The battery cover includes a housing surrounded by side walls formed on a bottom plate. A cover member of the battery cover for a portable electronic device is locked on a casing of the portable electronic device through cooperation of a moving member and an elastic member which are clamped and buckled on the cover. Further, a side wall of the housing comprises a concave recess inwardly.

Another example is provided by EP2273581A1 which discloses a housing for an electronic device. The housing comprises a back housing defining an interior compartment of the device, a receptacle to receive a first locking feature from a cover for the electronic device. A gap is formed by a depressed area on the back housing. The gap allows a user to place his fingernail underneath and pry the cover from the back housing.

Yet another example is provided by US4431113A which discloses a device for mounting a cover to a support member. The cover has a planar top surface and supports two side pieces protruding, from the top surface at approximately right angles. A latching device is supported by each side piece. Each latching device has a plurality of prongs and is supported by the side piece. The prongs are biased out of the plane of the side piece. Recesses, one for each latching device, are provided by the support member to mate with the latching devices when the cover is installed.

Hence, there is a need for an improved cover assembly for such devices.

### SUMMARY

In view of the above, it is an objective of the present invention to solve or at least reduce the drawbacks discussed above. The objective is at least partially achieved by a tool-less cover assembly, according to an embodiment of the present invention. The tool-less cover assembly includes a base plate and a cover plate. The cover plate includes a portion that extends over a periphery of the base plate. The cover plate may be lifted by contacting the portion of the cover plate by a user. The extension of the portion of the cover plate over the periphery of the base plate provides the user a gripping area for contacting the cover plate and forcing the cover plate away from the base plate during disassembly thereof.

According to an embodiment of the present invention, a notch is provided in the base plate and in association with the cover plate. The notch is adapted to provide a recess between the base plate and the cover plate in an assembled position thereof. The recess is adapted to receive one of more fingers of the user. The recess provides a contoured gripping area for holding the cover plate using the one or more fingers and forcing the cover plate away from the base plate during disassembly thereof.

According to an embodiment of the present invention, at least one locking tab is provided extending away from at least one of the cover plate and the base plate. Also, at least one tab receiving portion is provided on at least one of the base plate and the cover plate and in association with the at least one locking tab respectively. The at least one tab receiving portion is adapted to removably receive the at least one locking tab therein. The arrangement of the at least one locking tab and the at least one tab receiving portion provides to removably affix the cover plate with respect to the base plate.

According to an embodiment of the present invention, the at least one locking tab includes a plurality of locking tabs. Each of the plurality of locking tabs is disposed spaced apart with respect to one another. Also, the at least one tab receiving portion includes a plurality of tab receiving portions. Each of the plurality of tab receiving portions is disposed spaced apart with respect to one another and in association with respect to each of the plurality of locking tabs. The plurality of locking tabs and the plurality of tab receiving portions provide to distribute the locking tabs and the tab receiving portions around a surface of the cover plate and/or the base plate in turn providing distribution of a locking force around the surface of the cover plate and/or the base plate. The distribution of the locking tabs and the tab receiving portions also provide to affix the cover plate with respect to the base plate from all directions uniformly.

According to an embodiment of the present invention, at least one locking tab includes an enlarged portion on a distal end thereof. The enlarged portion is adapted to be snapped in to the at least one tab receiving portion. During assembly, the snapping of the enlarged portion of the at least one tab in to the at least one tab receiving portion provides a haptic and audible feedback to the user with respect to the at least one tab being affixed with respect to the at least one tab receiving portion.

According to an embodiment of the present invention, a height of the at least one locking tab is equal to an overall height of the cover plate. As such during assembly, if any of the at least one locking tab may be misaligned with respect to the respective at least one tab receiving portion, a portion of the cover plate around the misalignment may be raised and misaligned with respect to the base plate. This may provide an indication to the user of the misaligned at least one locking tab to be aligned correctly.

According to an embodiment of the present invention, at least one centering geometry is provided extending away from at least one of the cover plate and the base plate. Also, at least one receiving portion is provided on at least one of the base plate and the cover plate and in association with the at least one centering geometry respectively. The at least one receiving portion is adapted to removably receive the at least one centering geometry therein to align the cover plate with respect to the base plate. The arrangement of the at least one centering geometry and the at least one receiving portion provides a visual indication to the user to correctly align the cover plate with respect to the base plate during assembly thereof.

According to an embodiment of the present invention, the at least one centering geometry includes a first protrusion and a second protrusion intersecting the first protrusion. The first protrusion and the second protrusion provide a visual indication to correctly align the cover plate with respect to the base plate.

According to an embodiment of the present invention, the first protrusion intersects the second protrusion perpendicularly. An orientation of the first protrusion with respect to the second protrusion provides a poka-yoke feature in order to limit user error while aligning the cover plate with respect to the base plate during assembly thereof.

According to an embodiment of the present invention, the at least one centering geometry includes a plurality of centering geometries. Each of the plurality of centering geometries is disposed spaced apart with respect to one another. Also, the at least one receiving portion includes a plurality of receiving portions. Each of the plurality of receiving portions are disposed spaced apart with respect to one another and in association with respect to each of the plurality of centering geometries. The plurality of centering geometries and the plurality of receiving portions provide added visual indicators to the user in order to correctly aligning the cover plate with respect to the base plate during assembly thereof.

According to an embodiment of the present invention, a dimension of at least one of the plurality of centering geometries is different with respect to remaining of the plurality of centering geometries. The difference in dimension provides the poka-yoke feature in order to limit user error while aligning the cover plate with respect to the base plate during assembly thereof.

According to an embodiment of the present invention, the tool-less cover assembly also includes a first reinforcing rib extending, at least partially, along a surface of the base plate. The tool-less cover assembly further includes a second reinforcing rib extending, at least partially, along an inner surface of the cover plate and in association with the first reinforcing rib. The first reinforcing rib and the second reinforcing rib are adapted to contact one another in the assembled position of the cover plate with respect to the base plate. The first reinforcing rib and the second reinforcing rib provide reinforcement and structural rigidity to the base plate and the cover plate respectively and limits flexing thereof.

According to an embodiment of the present invention, the cover plate includes a grooved protrusion extending from an inner surface thereof. The grooved protrusion is provided in association with the notch provided in the base plate. The grooved protrusion is adapted to removably receive one or more cables therein. As such, the grooved protrusion provides cable management and limits tangling/damage to the cables due to bending stress.

According to an embodiment of the present invention, each of the base plate and the cover plate includes an edge thereof. The edges are adapted to, at least partially, contact one another in the assembled position of the cover plate with respect to the base plate. As such, when the edges may contact one another, the cover plate and the base plate may provide a complete enclosure in order to limit entry of dust, moisture, accidental touch, and so on within the device. Also, in the assembled position, the plurality of locking tabs, the plurality of tab receiving portions, the plurality of centering geometries, and the plurality of receiving portions are hidden within the cover plate and the base plate providing high quality aesthetics to the device.

According to an embodiment of the present invention, the device is a valve control unit. As such, the cover plate and the base plate provide ease of access to internal portions of the device for assembly, disassembly, serviceability, and so on. Also, the device may be mounted to any location as per application requirements, such as a wall, an electric panel, and so on.

Other features and aspects of this invention will be apparent from the following description and the accompanying drawings.

### BRIEF DESCRIPTION OF THE DRAWINGS

The invention will be described in more detail with reference to the enclosed drawings, wherein:
**FIG. 1** shows a perspective view of an exemplary device having a tool-less cover assembly, in accordance with an embodiment of the present invention;
**FIG. 2** shows an inverted perspective view of a cover plate of the tool-less cover assembly, in accordance with an embodiment of the present invention;
**FIG. 3** shows a top view of a base plate of the tool-less cover assembly, in accordance with an embodiment of the present invention; and
**FIG. 4** shows a cross sectional view of the tool-less cover assembly along a plane A-A' shown in **FIGS. 1-3**, in accordance with an embodiment of the present invention.

### DESCRIPTION OF EMBODIMENTS

The present invention will be described more fully hereinafter with reference to the accompanying drawings, in which example embodiments of the invention incorporating one or more aspects of the present invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. For example, one or more aspects of the present invention may be utilized in other embodiments and even other types of structures and/or methods. In the drawings, like numbers refer to like elements.

Certain terminology is used herein for convenience only and is not to be taken as a limitation on the invention. For example, "side", "lateral", "inner", "outer", "between", "distal", "opposite", "smaller", "greater", "partially", "approximately", "substantially", "planar", "overall" or the like, merely describe the configuration shown in the Figures. Indeed, the components may be oriented in any direction and the terminology, therefore, should be understood as encompassing such variations unless specified otherwise.

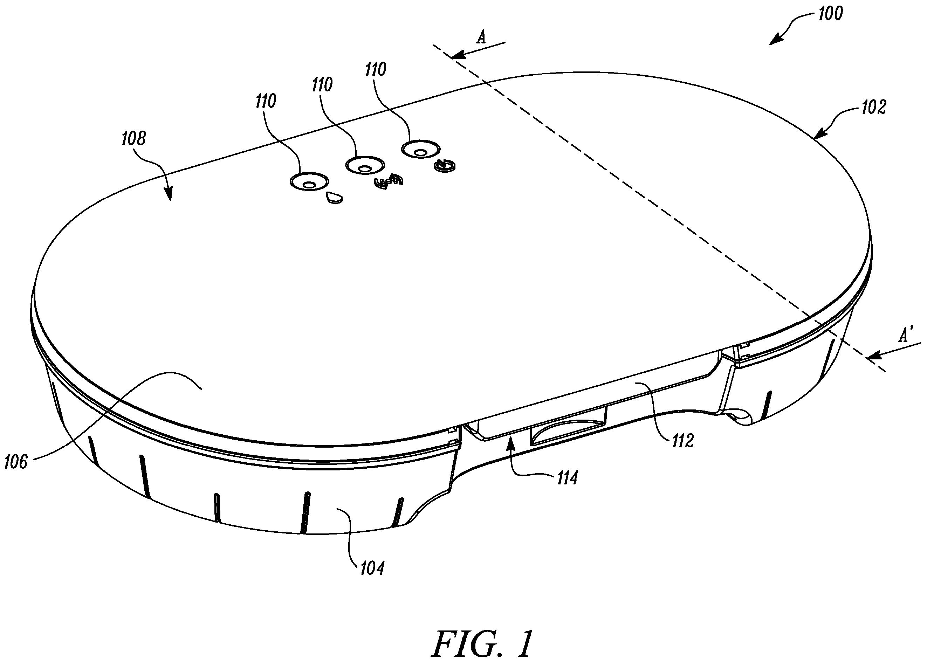

Referring to **FIG. 1**, a perspective view of an exemplary device **100** is illustrated. In the illustrated embodiment, the device **100** is a valve control unit. In other embodiments, the device **100** may be any other device known in the art, such as an electrical/electronic control unit, a control console of an appliance or a machine tool or indoor/outdoor equipment, and so on. The device **100** includes a substantially flat, elongated, and curved configuration. In other embodiments, the device **100** may include any other configuration including, but not limited to, a rectangular configuration, a triangular configuration, a cylindrical configuration, and an oval configuration.

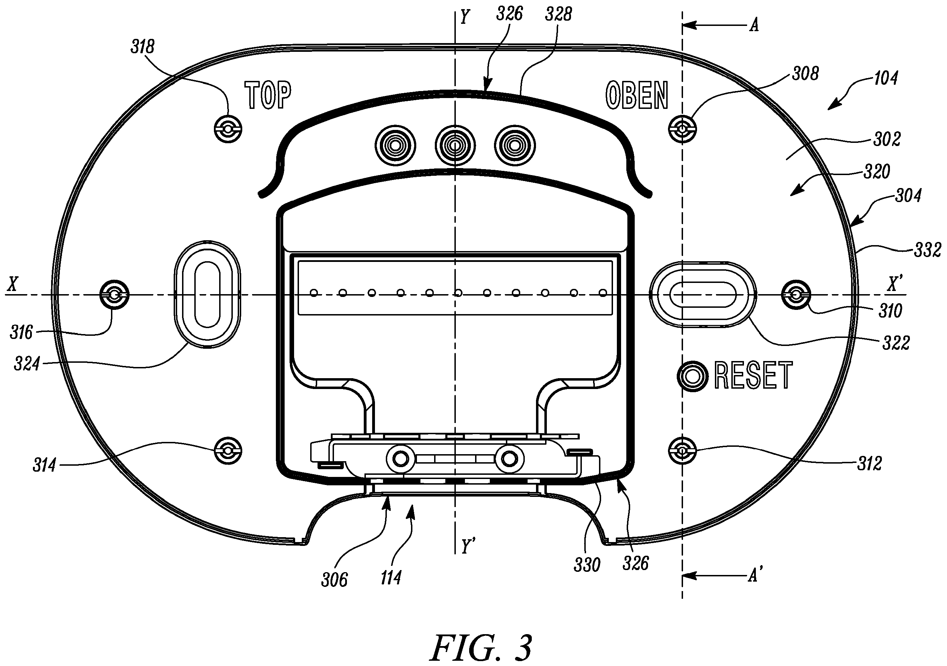

The device **100** includes a tool-less cover assembly **102.** The tool-less cover assembly **102** will be hereinafter interchangeably referred to as the "cover assembly **102**". The cover assembly **102** includes a base portion **104.** The base portion **104** is adapted to receive a base plate **302** (shown in **FIG. 3**) thereon. The base plate **302** will be described in more detail later with reference to **FIG. 3****.** The base portion **104** includes a substantially hollow configuration. Accordingly, the base portion **104** is adapted to enclose one or more elements (not shown) of the device **100** below the base plate **302** including, but not limited to, one or more Printed Circuit Boards (PCBs), switching elements, circuitry elements, visual indicators such as Light Emitting Diodes (LEDs), audible indicators such as beepers, cables, and fastening elements.

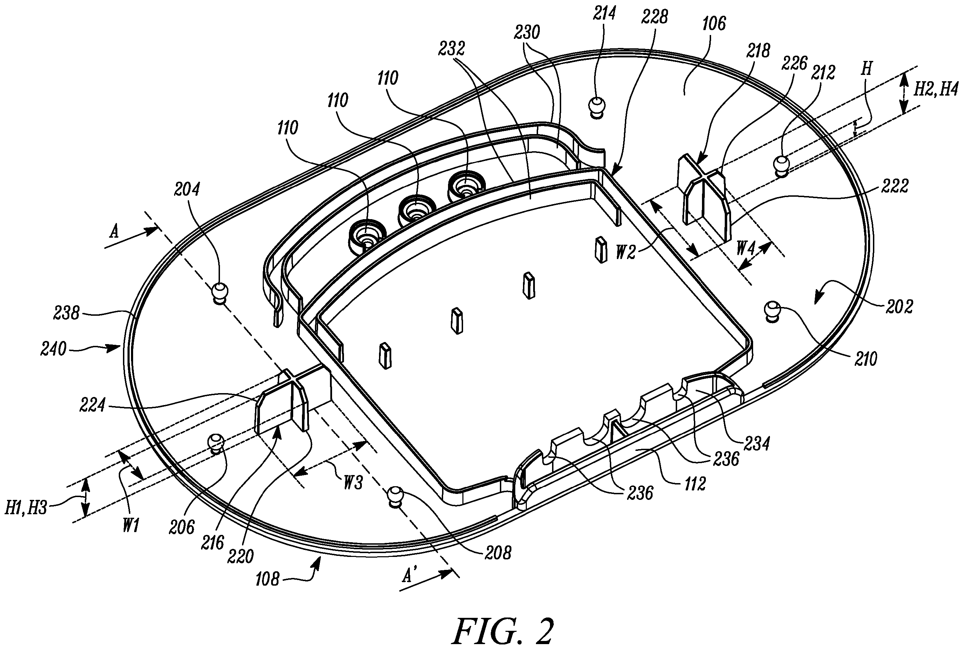

The cover assembly **102** also includes a cover plate **106.** The cover plate **106** is adapted to be removably affixed to the base plate **302.** Referring to **FIGS. 1** and **2**, the cover plate **106** includes a substantially planar configuration. The cover plate **106** includes a first side **108** and a second side **202.** The second side **202** is disposed opposite with respect to the first side **108.** In the illustrated embodiment, the first side **108** and the second side **202** refer to an outer surface and an inner surface respectively of the cover plate **106.** In other embodiments, the first side **108** and the second side **202** may be interchangeably referred to the inner surface and the outer surface respectively of the cover plate **106.**

Referring to **FIG. 1**, the first side **108** of the cover plate **106** includes a number of visual indicators **110,** such as a device status indicator, a connectivity indicator, an operational state indicator, and so on. In the illustrated embodiment, the cover plate **106** includes three visual indicators **110** provided therein. In other embodiments, the cover plate **106** may include a single or multiple visual indicators based on application requirements. Additionally or optionally, the cover plate **106** may also include one or more elements thereon, such as an audible indicator, a switch, a display unit, a touchscreen unit, and so on based on application requirements.

Referring to **FIG. 2**, the second side **202** of the cover plate **106** includes at least one locking tab extending away therefrom. More specifically, the second side **202** includes a plurality of locking tabs **204, 206, 208, 210, 212, 214** provided thereon. Each of the plurality of locking tabs **204, 206, 208, 210, 212, 214** is disposed spaced apart from one another. In the illustrated embodiment, the second side **202** includes six locking tabs **204, 206, 208, 210, 212, 214** provided thereon and disposed spaced apart from one another. In other embodiments, the second side **202** may include a single or multiple locking tabs based on application requirements.

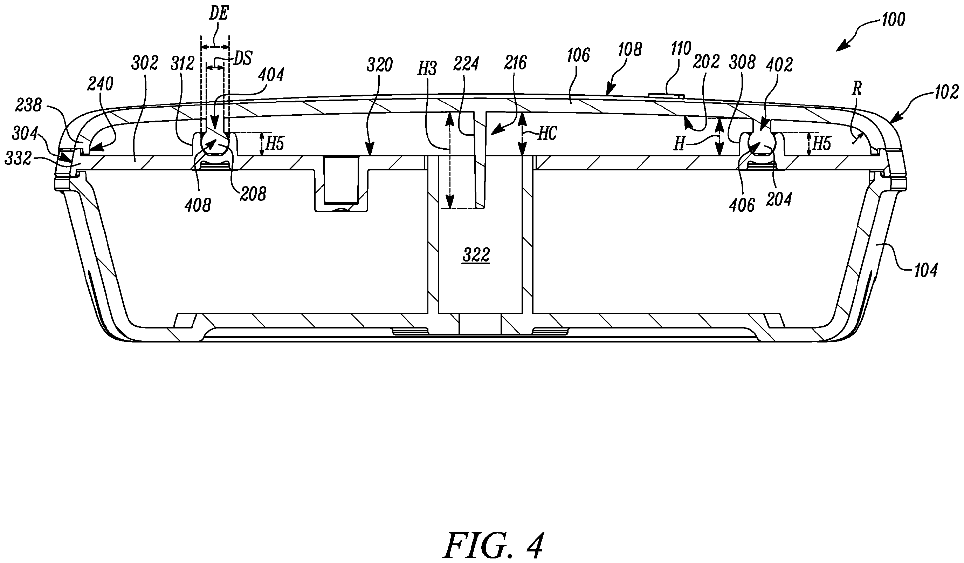

A configuration of the plurality of locking tabs **204, 206, 208, 210, 212, 214** will now be explained in more detail with reference to **FIG. 4****.** Referring to **FIG. 4****,** a cross sectional view of the cover assembly **102** along a plane **A-A'** (shown in **FIGS. 1-3**) is illustrated. For the purpose of explanation, the locking tabs **204, 208** will be explained in more detail. It should be noted that a configuration of each of the other locking tabs **206, 210, 212, 214** is similar to the configuration of the locking tabs **204, 208.** Each of the locking tabs **204, 208** includes a substantially elongated configuration defining a height "**H**" thereof. In the illustrated embodiment, the height "**H**" of each of the plurality of locking tabs **204, 206, 208, 210, 212, 214** is equal to one another. In other embodiments, the height "**H**" of one or more of the plurality of locking tabs **204, 206, 208, 210, 212, 214** may be different with respect to one another.

Each of the locking tabs **204, 208** includes a stem portion **402, 404** and an enlarged portion **406, 408** connected to the stem portion **402, 404** respectively. The stem portion **402, 404** is connected to the second side **202** of the cover plate **106.** The enlarged portion **406, 408** is disposed on the stem portion **402, 404** respectively in a manner such that the enlarged portion **406, 408** is distal with respect to the second side **202** of the cover plate **106.** In the illustrated embodiment, the stem portion **402, 404** includes a substantially cylindrical configuration and the enlarged portion **406, 408** includes a substantially spherical configuration. Accordingly, a diameter "**DE**" of the enlarged portion **406, 408** is substantially greater with respect to a diameter "**DS**" of the stem portion **402, 404.** In other embodiments, the stem portion **402, 404** and/or the enlarged portion **406, 408** may include any other configuration known in the art, such as a substantially flatter configuration.

Referring to **FIG. 2**, the second side **202** of the cover plate **106** also includes at least one centering geometry extending away therefrom. More specifically, the second side **202** includes a plurality of centering geometries **216, 218** provided thereon. Each of the plurality of centering geometries **216, 218** is disposed spaced apart from one another. In the illustrated embodiment, the second side **202** includes two centering geometries **216, 218** provided thereon and disposed spaced apart from one another. In other embodiments, the second side **202** may include a single or multiple centering geometries based on application requirements.

Each of the plurality of centering geometries **216, 218** includes a first protrusion **220, 222** and a second protrusion **224, 226** respectively. Each of the first protrusion **220, 222** and the second protrusion **224, 226** extends away from the second side **202** of the cover plate **106.** Also, each of the first protrusion **220, 222** and the second protrusion **224, 226** intersects one another respectively. In the illustrated embodiments, each of the first protrusion **220, 222** and the second protrusion **224, 226** intersects perpendicularly with one another respectively. In other embodiments, each of the first protrusion **220, 222** and the second protrusion **224, 226** may intersect one another respectively at any other angular value based on application requirements.

Each of the first protrusions **220, 222** includes an elongated configuration defining a height "**H1**", "**H2**" and a width "**W1**", "**W2**" respectively. Each of the second protrusions **224, 226** also includes an elongated configuration defining a height "**H3**", "**H4**" and a width "**W3**", "**W4**" respectively. In the illustrated embodiments, the height "**H1**", "**H2**", "**H3**", "**H4**" of each of the first protrusions **220, 222** and the second protrusions **224, 226** respectively is equal to one another. The height "**H1**", "**H2**", "**H3**", "**H4**" of each of the first protrusions **220, 222** and the second protrusions **224, 226** respectively is substantially greater with respect to the height "**H**" of each of the plurality of locking tabs **204, 206, 208, 210, 212, 214.**

Accordingly, during assembly of the cover assembly **102,** any undesired lateral force resulting due to incorrect alignment of the cover plate **106** with respect to the base plate **302** may be taken up by the plurality of centering geometries **216, 218** instead of the plurality of locking tabs **204, 206, 208, 210, 212, 214.** This may limit breakage of one or more of the plurality of locking tabs **204, 206, 208, 210, 212, 214** during assembly of the cover plate **106.** Also, smaller height "**H**" of each of the plurality of locking tabs **204, 206, 208, 210, 212, 214** with respect to the height "**H1**", "**H2**", "**H3**", "**H4**" of each of the first protrusions **220, 222** and the second protrusions **224, 226** respectively enables use of low mounting force by a user while affixing the cover plate **106** with respect to the base plate **302.**

In other embodiments, the height "**H1**", "**H2**", "**H3**", "**H4**" of one or more of the first protrusions **220, 222** and/or the second protrusions **224, 226** respectively may be different with respect to one another. Further, in the illustrated embodiments, the width "**W1**", "**W2**", "**W3**", "**W4**" of each of the first protrusions **220**, **222** and the second protrusions **224**, **226** respectively is different with respect to one another. Alternatively, in other embodiments, the width "**W1**", "**W2**", "**W3**", "**W4**" of one or more of the first protrusion **220, 222** and/or the second protrusion **224, 226** respectively may be equal with respect to one another.

The cover plate **106** also includes a first reinforcing rib **228** provide thereon. More specifically, the first reinforcing rib **228** is provided extending, at least partially, along the second side **202** of the cover plate **106.** In the illustrated embodiment, the first reinforcing rib **228** includes a first pair of reinforcing ribs **230** and a second pair of reinforcing ribs **232.** The first pair of reinforcing ribs **230** extends along the second side **202** of the cover plate **106** forming a substantially C-shaped configuration. The second pair of reinforcing ribs **232** extends along the second side **202** of the cover plate **106** forming a substantially square shaped configuration. Also, the first pair of reinforcing ribs **230** and the second pair of reinforcing ribs **232** are provided in contact with one another.

The first reinforcing rib **228** including the first pair of reinforcing ribs **230** and the second pair of reinforcing ribs **232** is adapted to provide structural rigidity to the cover plate **106** against flexing. Also, the configuration of the first reinforcing rib **228** including the first pair of reinforcing ribs **230** and the second pair of reinforcing ribs **232** described herein is merely exemplary and may vary based on application requirements. For example, in other embodiments, the first reinforcing rib **228** may include any other configuration, such as a triangular configuration, a linear configuration, a circular configuration, a serpentine configuration, and so on.

The cover plate **106** also includes a grooved protrusion **234** extending from the second side **202** thereof. The grooved protrusion **234** is provided in contact with the first reinforcing rib **228,** and more specifically with the second pair of reinforcing ribs **232.** The grooved protrusion **234** includes a plurality of grooves **236** provided therein. Each of the plurality of grooves **236** is spaced apart with respect to one another.

In the illustrated embodiments, the grooved protrusion **234** includes four grooves **236.** In other embodiments, the grooved protrusion **234** may include a single or multiple grooves based on application requirements. Each of the plurality of grooves **236** of the grooved protrusion **234** is adapted to receive a cable (not shown) therein. The grooved protrusion **234** provides improved cable management, reduced bending stress, and in turn limits structural damage to the cables entering/exiting the device **100.**

The cover plate **106** also includes a curved edge **238** extending along a periphery **240** thereof. Referring to **FIG. 4****,** the curved edge **238** extends from the first side **108** towards the second side **202** defining a radius of curvature "**R**" thereof. Also, the curved edge **238** defines an overall height "**HC**" of the cover plate **106.** The overall height "**HC**" is approximately equal with respect to the height "**H**" of each of the plurality of locking tabs **204, 206, 208, 210, 212, 214** respectively. In other embodiments, the overall height "**HC**" may be smaller or greater with respect to the height "**H**" of each of the plurality of locking tabs **204, 206, 208, 210, 212, 214** respectively based on application requirements.

Referring to **FIG. 3**, the cover assembly **102** also includes the base plate **302.** The base plate **302** is removably affixed to the base portion **104** using one or more fastening elements (not shown), such as screws, bolts, tabs, clips, and so on. The base plate **302** includes a substantially planar configuration defining a periphery **304** thereof. Also, an overall configuration of the base plate **302** is similar to the overall configuration of the cover plate **106** and the base portion **104.** The base plate **302** is sized partially smaller with respect to a size of the cover plate **106.** Accordingly, in the assembled position of the cover assembly **102,** a portion **112** (shown in **FIGS. 1** and **2**) of the cover plate **106** extends laterally over the periphery **304** of the base plate **302.**

As such, the cover plate **106** may be contacted around the portion **112** by the user in order to lift the cover plate **106** with respect to the base plate **302.** In some embodiments, the complete periphery **240** of the cover plate **106** may extend laterally with respect to the periphery **304** of the base plate **302.** In such a situation, the cover plate **106** may be contacted anywhere around the periphery **240** thereof by the user in order to lift the cover plate **106** with respect to the base plate **302.**

In the illustrated embodiment, the base portion **104** includes a notch **306** provided extending, at least partially, along the periphery **304** thereof. The notch **306** is provided in association with the portion **112** and the grooved protrusion **234** of the cover plate **106.** In the assembled position of the cover assembly **102,** the notch **306** provides a recess **114** (shown in **FIGS. 1** and **3**) between the periphery **240** of the cover plate **106** and the periphery **304** of the base plate **302.** The recess **114** is adapted to receive one or more fingers of the user or any contacting element such as a coin in order to grip or contact the portion **112** of the cover plate **106** respectively. Accordingly, a force may be applied around the portion **112** in order to separate the cover plate **106** with respect to the base plate **302.**

The base plate **302** also includes at least one tab receiving portion provided thereon. The at least one tab receiving portion is provided in association with the at least one locking tab provided on the cover plate **106.** More specifically, the base plate **302** includes a plurality of tab receiving portions **308, 310, 312, 314, 316, 318** provided thereon. Each of the plurality of tab receiving portions **308, 310, 312, 314, 316, 318** is provided in association with each of the plurality of locking tabs **204, 206, 208, 210, 212, 214** respectively. Each of the plurality of tab receiving portions **308, 310, 312, 314, 316, 318** includes a substantially hollow and spherical configuration.

Each of the plurality of tab receiving portions **308, 310, 312, 314, 316, 318** is disposed spaced apart from one another. In the illustrated embodiment, the base plate **302** includes six tab receiving portions **308, 310, 312, 314, 316, 318** provided thereon and disposed spaced apart from one another. In other embodiments, the base plate **302** may include a single or multiple tab receiving portions based on application requirements. During assembly of the cover assembly **102,** each of the plurality of tab receiving portions **308, 310, 312, 314, 316, 318** is adapted to receive each of the plurality of locking tabs **204, 206, 208, 210, 212, 214** respectively in order to removably affix the cover plate **106** with respect to the base plate **302.**

The configuration of the plurality of tab receiving portions **308, 310, 312, 314, 316, 318** will now be explained in more detail with reference to **FIG. 4****.** For the purpose of explanation, the tab receiving portions **308, 312** will be explained in more detail. It should be noted that the configuration of each of the other tab receiving portions **310, 314, 316, 318** is similar to the configuration of the tab receiving portions **308, 312.** Referring to **FIG. 4**, each of the tab receiving portions **308, 312** is substantially raised with respect to a surface **320** of the base plate **302** defining a height "**H5**" thereof. The raised configuration provides a visual indication to the user to correctly align each of the tab receiving portions **308, 312** with respect to each of the locking tabs **204, 208** respectively during assembly.

The height "**H5**" is approximately equal to the diameter "**DE**" of the enlarged portion **406, 408** of each of the locking tabs **204, 208.** Also, the configuration of each of the tab receiving portions **308, 312** is similar to the configuration of the enlarged portions **406, 408** of each of the locking tabs **204, 208** respectively. Accordingly, during assembly, the enlarged portion **406, 408** of each of the locking tabs **204, 208** is adapted to be snapped in to each of the tab receiving portions **308, 312** respectively. The snapping effect provides a haptical feedback to the user with respect to each of the plurality of locking tabs **204, 206, 208, 210, 212, 214** being received and removably locked within each of the plurality of tab receiving portions **308, 310, 312, 314, 316, 318** respectively.

Referring to **FIG. 3**, the base plate **302** also includes at least one receiving portion provided thereon. The at least one receiving portion is provided in association with the at least one centering geometry provided on the cover plate **106.** More specifically, the base plate **302** includes a plurality of receiving portions **322, 324** provided thereon. Each of the plurality of receiving portions **322, 324** is provided in association with each of the plurality of centering geometries **216, 218** respectively. Each of the plurality of receiving portions **322, 324** includes a substantially hollow and oval configuration.

Each of the plurality of receiving portions **322, 324** is disposed spaced apart from one another. In the illustrated embodiment, the base plate **302** includes two receiving portions **322, 324** provided thereon and disposed spaced apart from one another. In other embodiments, the base plate **302** may include a single or multiple receiving portions based on application requirements. During assembly of the cover assembly **102,** each of the plurality of receiving portions **322, 324** is adapted to receive each of the plurality of centering geometries **216, 218** respectively to align the cover plate **106** with respect to the base plate **302.**

In the illustrated embodiment, each of the plurality of receiving portions **322, 324** is oriented differently with respect to one another. For example, the receiving portion **322** is oriented along an axis **X-X'** and the receiving portion **324** is oriented along an axis **Y-Y'**. The orientation of each of the plurality of receiving portions **322, 324** with respect to one another is based on difference of the width "**W1**", "**W2**", "**W3**", "**W4**" of each of the first protrusions **220**, **222** and the second protrusions **224**, **226** of each of the plurality of centering geometries **216**, **218** respectively. The differently oriented each of the plurality of receiving portions **322, 324** provides a visual indication to the user and a poka-yoke feature in order to correctly align the cover plate **106** with respect to the base plate **302** during assembly.

The base plate **302** also includes a second reinforcing rib **326** provided thereon. More specifically, the second reinforcing rib **326** is provided extending, at least partially, along the surface **320** of the base plate **302.** In the illustrated embodiment, the second reinforcing rib **326** includes a first auxiliary rib **328** and a second auxiliary rib **330.** The first auxiliary rib **328** and the second auxiliary rib **330** is provided in association with the first pair of reinforcing ribs **230** and the second pair of reinforcing ribs **232** provided on the cover plate **106** respectively

Accordingly, the first auxiliary rib **328** extends along the surface **320** of the base plate **302** forming a substantially C-shaped configuration. The second auxiliary rib **330** extends along the surface **320** of the base plate **302** forming a substantially square shaped configuration. The first auxiliary rib **328** and the second auxiliary rib **330** are adapted to provide structural rigidity to the base plate **302** against flexing. Also, the configuration of the second reinforcing rib **326** described herein is merely exemplary and may vary based on the configuration of the first reinforcing rib **228** provided on the cover plate **106.**

During assembly of the cover assembly **102,** the first auxiliary rib **328** is adapted to be received within the first pair of reinforcing ribs **230** provided on the cover plate **106.** Similarly, the second auxiliary rib **330** is adapted to be received within the second pair of reinforcing ribs **232** provided on the cover plate **106.**

The base plate **302** also includes an edge **332** extending along the periphery **304** thereof. Referring to **FIG. 4**, in the assembled position of the cover assembly **102,** the edge **332** is adapted to contact the curved edge **238** of the cover plate **106.** As such, in the assembled position, the cover plate **106** in association with the base plate **302** provides an enclosure in order to limit accidental touch to internal components of the device **100** and/or entry of foreign material such as dust, moisture, and so on within the device **100.**

In the illustrated embodiments, the plurality of locking tabs **204, 206, 208, 210, 212, 214** is provided on the second side **202** of the cover plate **106** whereas the plurality of tab receiving portions **308, 310, 312, 314, 316, 318** is provided on the base plate **302.** It should be noted that in other embodiments, an arrangement of the plurality of locking tabs **204, 206, 208, 210, 212, 214** and the plurality of tab receiving portions **308, 310, 312, 314, 316, 318** may be reversed such that the plurality of locking tabs **204, 206, 208, 210, 212, 214** may be provided on the base plate **302** whereas the plurality of tab receiving portions **308, 310, 312, 314, 316, 318** may be provided on the second side **202** of the cover plate **106.** Additionally, in some embodiments, one or more of the plurality of locking tabs **204, 206, 208, 210, 212, 214** may be provided on the second side **202** of the cover plate **106** and the remaining of the plurality of locking tabs **204, 206, 208, 210, 212, 214** may be provided on the base plate **302.** Similarly, one or more of the plurality of tab receiving portions **308, 310, 312, 314, 316, 318** may be provided on the base plate **302** and the remaining of the plurality of tab receiving portions **308, 310, 312, 314, 316, 318** may be provided on the second side **202** of the cover plate **106.**

Further, in the illustrated embodiments, the plurality of centering geometries **216, 218** is provided on the second side **202** of the cover plate **106** whereas the plurality of receiving portions **322, 324** is provided on the base plate **302.** It should be noted that in other embodiments, an arrangement of the plurality of centering geometries **216, 218** and the plurality of receiving portions **322, 324** may be reversed such that the plurality of centering geometries **216, 218** may be provided on the base plate **302** whereas the plurality of receiving portions **322, 324** may be provided on the second side **202** of the cover plate **106.** Additionally, in some embodiments, one or more of the plurality of centering geometries **216, 218** may be provided on the second side **202** of the cover plate **106** and the remaining of the plurality of centering geometries **216, 218** may be provided on the base plate **302.** Similarly, one or more of the plurality of receiving portions **322, 324** may be provided on the base plate **302** and the remaining of the plurality of receiving portions **322, 324** may be provided on the second side **202** of the cover plate **106.**

In the drawings and specification, there have been disclosed preferred embodiments and examples of the invention and, although specific terms are employed, they are used in a generic and descriptive sense only and not for the purpose of limitation of the scope of the invention being set forth in the following claims.

### LIST OF ELEMENTS

- 100: Device
- 102: Cover Assembly
- 104: Base Portion
- 106: Cover Plate
- 108: First Side
- 110: Visual Indicator
- 112: Portion
- 114: Recess
- 202: Second Side
- 204: Locking Tab
- 206: Locking Tab
- 208: Locking Tab
- 210: Locking Tab
- 212: Locking Tab
- 214: Locking Tab
- 216: Centering Geometry
- 218: Centering Geometry
- 220: First Protrusion
- 222: First Protrusion
- 224: Second Protrusion
- 226: Second Protrusion
- 228: First Reinforcing Rib
- 230: First Pair of Reinforcing Ribs
- 232: Second Pair of Reinforcing Ribs
- 234: Grooved Protrusion
- 236: Groove
- 238: Curved Edge
- 240: Periphery
- 302: Base Plate
- 304: Periphery
- 306: Notch
- 308: Tab Receiving Portion
- 310: Tab Receiving Portion
- 312: Tab Receiving Portion
- 314: Tab Receiving Portion
- 316: Tab Receiving Portion
- 318: Tab Receiving Portion
- 320: Surface
- 322: Receiving Portion
- 324: Receiving Portion
- 326: Second Reinforcing Rib
- 328: First Auxiliary Rib
- 330: Second Auxiliary Rib
- 332: Edge
- 402: Stem Portion
- 404: Stem Portion
- 406: Enlarged Portion
- 408: Enlarged Portion
- H: Height of Locking Tab
- HC: Overall Height of Cover Plate
- H1: Height of First Protrusion
- H2: Height of First Protrusion
- H3: Height of Second Protrusion
- H4: Height of Second Protrusion
- H5: Height of Tab Receiving Portion
- W1: Width of First Protrusion
- W2: Width of First Protrusion
- W3: Width of Second Protrusion
- W4: Width of Second Protrusion
- DE: Diameter of Enlarged Portion
- DS: Diameter of Stem Portion
- R: Radius of Curvature
- A-A': Plane
- X-X': Axis
- Y-Y': Axis

## Claims

1. A tool-less cover assembly (**102**) for an electrical or electronic device (**100**), the tool-less cover assembly (**102**) comprising:
a base plate (**302**);
a base portion (**104**) adapted to receive the base plate (**302**) and adapted to enclose one or more elements;
a cover plate (**106**) adapted to be removably affixed to the base plate (**302**);
a notch (**306**) provided in the base plate (**302**) and in association with the cover plate (**106**), the notch (**306**) adapted to provide a recess (**114**) between the base plate (**302**) and the cover plate (**106**) in an assembled position;
**characterized in that**:
a periphery (240) of the cover plate (**106**) extends over a periphery (**304**) of the base plate (**302**), such that the cover plate (**106**) can be lifted by contacting a portion (**112**) of the cover plate (**106**) by a user;
wherein the cover plate (106) includes a single or multiple visual indicators (110).

2. The tool-less cover assembly (**102**) of claim 1, wherein the recess (**114**) is adapted to receive one of more fingers of the user.

3. The tool-less cover assembly (**102**) of claim 1 and 2, further comprising:
at least one locking tab extending away from at least one of the cover plate (**106**) and the base plate (**302**); and
at least one tab receiving portion provided on at least one of the base plate (**302**) and the cover plate (**106**) and in association with the at least one locking tab respectively, wherein the at least one tab receiving portion is adapted to removably receive the at least one locking tab therein to removably affix the cover plate (**106**) with respect to the base plate (**302**).

4. The tool-less cover assembly (**102**) of claim 1-3, wherein:
the at least one locking tab includes a plurality of locking tabs (**204, 206, 208, 210, 212, 214**), each of the plurality of locking tabs (**204, 206, 208, 210, 212, 214**) disposed spaced apart with respect to one another; and
the at least one tab receiving portion includes a plurality of tab receiving portions (**308, 310, 312, 314, 316, 318**), each of the plurality of tab receiving portions (**308, 310, 312, 314, 316, 318**) disposed spaced apart with respect to one another and in association with respect to each of the plurality of locking tabs (**204, 206, 208, 210, 212, 214**).

5. The tool-less cover assembly (**102**) of claim 4, wherein the at least one locking tab includes an enlarged portion (**406, 408**) on a distal end thereof, the enlarged portion (**406, 408**) adapted to be snapped in to the at least one tab receiving portion.

6. The tool-less cover assembly (**102**) of claim 4 and 5, wherein a height (**H**) of the at least one locking tab is equal to an overall height (**HC**) of the cover plate (**106**).

7. The tool-less cover assembly (**102**) of claim 1 further comprising:
at least one centering geometry extending away from at least one of the cover plate (**106**) and the base plate (**302**); and
at least one receiving portion provided on at least one of the base plate (**302**) and the cover plate (**106**) and in association with the at least one centering geometry respectively, wherein the at least one receiving portion is adapted to removably receive the at least one centering geometry therein to align the cover plate (**106**) with respect to the base plate (**302**).

8. The tool-less cover assembly (**102**) of claim 7, wherein the at least one centering geometry includes a first protrusion (**220, 222**) and a second protrusion (**224, 226**) intersecting the first protrusion (**220, 222**).

9. The tool-less cover assembly (**102**) of claim 8, wherein the first protrusion (**220, 222**) intersects the second protrusion (**224, 226**) perpendicularly.

10. The tool-less cover assembly (**102**) of claim 7, wherein:
the at least one centering geometry includes a plurality of centering geometries (**216, 218**), wherein each of the plurality of centering geometries (**216, 218**) are disposed spaced apart with respect to one another; and
the at least one receiving portion includes a plurality of receiving portions (**322, 324**), wherein each of the plurality of receiving portions (**322, 324**) is disposed spaced apart with respect to one another and in association with respect to each of the plurality of centering geometries (**216, 218**).

11. The tool-less cover assembly (**102**) of claim 7, wherein a dimension of at least one of the plurality of centering geometries (**216, 218**) is different with respect to remaining of the plurality of centering geometries (**216, 218**).

12. The tool-less cover assembly (**102**) of claim 1-11 further comprising:
a first reinforcing rib (**228**) extending, at least partially, along an inner surface of the cover plate (**106**); and
a second reinforcing rib (**326**) extending, at least partially, along a surface (**320**) of the base plate (**302**) and in association with the first reinforcing rib (**228**),
wherein the first reinforcing rib (**228**) and the second reinforcing rib (**326**) are adapted to be located aside each other in an assembled position of the cover plate (**106**) with respect to the base plate (**302**).

13. The tool-less cover assembly (**102**) of claim 1-12, wherein the cover plate (**106**) includes a grooved protrusion (**234**) extending from an inner surface thereof, the grooved protrusion (**234**) provided in association with the notch (**306**) provided in the base plate (**302**), the grooved protrusion (**234**) adapted to removably receive one or more cables therein.

14. The tool-less cover assembly (**102**) of claim 1-13, wherein each of the base plate (**302**) and the cover plate (**106**) includes an edge (**238, 332**) thereof, the edges (**238, 332**) adapted to, at least partially, contact one another in an assembled position of the cover plate (**106**) with respect to the base plate (**302**).

15. The tool-less cover assembly (**102**) of claim 1-14, wherein the device (**100**) is a valve control unit.

## Patentansprüche

1. Werkzeuglose Abdeckungsanordnung (102) für ein elektrisches oder elektronisches Gerät (100), wobei die werkzeuglose Abdeckungsanordnung (102) umfasst:
eine Grundplatte (302);
einen Grundabschnitt (104), der ausgelegt ist, die Grundplatte (302) aufzunehmen und geeignet ist, ein oder mehrere Elemente zu umschließen;
eine Abdeckplatte (106), die ausgelegt ist, um abnehmbar an der Grundplatte (302) befestigt zu werden;
eine Aussparung (306), die in der Grundplatte (302) und in Verbindung mit der Abdeckplatte (106) vorgesehen ist, wobei die Aussparung (306) angepasst ist, um eine Aussparung (114) zwischen der Grundplatte (302) und der Abdeckplatte (106) in einer zusammengesetzten Position bereitzustellen;
**dadurch gekennzeichnet, dass**:
ein Umfang (240) der Abdeckplatte (106) sich über einen Umfang (304) der Grundplatte (302) erstreckt, so dass die Abdeckplatte (106) durch Berühren eines Abschnitts (112) der Abdeckplatte (106) durch einen Benutzer angehoben werden kann;
wobei die Abdeckplatte (106) eine einzelne oder mehrere optische Anzeigen (110) umfasst.

2. Werkzeuglose Abdeckungsanordnung (102) nach Anspruch 1, wobei die Aussparung (114) zur Aufnahme eines oder mehrerer Finger des Benutzers ausgelegt ist.

3. Werkzeuglose Abdeckungsanordnung (102) nach Anspruch 1 und 2, ferner umfassend:
mindestens eine Verriegelungslasche, die sich von mindestens einer der Abdeckplatte (106) und der Grundplatte (302) weg erstreckt; und
mindestens einen Laschenaufnahmeabschnitt, der an mindestens einer von der Grundplatte (302) und der Abdeckplatte (106) und in Verbindung mit der jeweils mindestens einen Verriegelungslasche vorgesehen ist, wobei der mindestens eine Laschenaufnahmeabschnitt ausgelegt ist, um die mindestens eine Verriegelungslasche darin entfernbar aufzunehmen, um die Abdeckplatte (106) in Bezug auf die Grundplatte (302) abnehmbar zu befestigen.

4. Werkzeuglose Abdeckungsanordnung (102) nach Anspruch 1-3, wobei:
die mindestens eine Verriegelungslasche eine Vielzahl von Verriegelungslaschen (204, 206, 208, 210, 212, 214) umfasst, wobei jede der Vielzahl von Verriegelungslaschen (204, 206, 208, 210, 212, 214) mit Abstand zueinander angeordnet ist; und
der mindestens eine Laschenaufnahmeabschnitt eine Vielzahl von Laschenaufnahmeabschnitten (308, 310, 312, 314, 316, 318) umfasst, wobei jeder der Vielzahl von Laschenaufnahmeabschnitten (308, 310, 312, 314, 316, 318) in Bezug zueinander beabstandet und in Zuordnung zu jeder der Vielzahl von Verriegelungslaschen (204, 206, 208, 210, 212, 214) angeordnet ist.

5. Werkzeuglose Abdeckungsanordnung (102) nach Anspruch 4, wobei die mindestens eine Verriegelungslasche einen vergrößerten Abschnitt (406, 408) an einem distalen Ende umfasst, wobei der vergrößerte Abschnitt (406, 408) so ausgelegt ist, dass er in den mindestens einen Laschenaufnahmeabschnitt eingeschnappt werden kann.

6. Werkzeuglose Abdeckungsanordnung (102) nach Anspruch 4 und 5, wobei eine Höhe (H) der mindestens einen Verriegelungslasche gleich einer Gesamthöhe (HC) der Abdeckplatte (106) ist.

7. Werkzeuglose Abdeckungsanordnung (102) nach Anspruch 1, ferner umfassend:
mindestens eine Zentriergeometrie, die sich von mindestens einer der Abdeckplatte (106) und der Grundplatte (302) weg erstreckt; und
mindestens einen Aufnahmeabschnitt, der an mindestens einer von der Grundplatte (302) und der Abdeckplatte (106) und in Verbindung mit der jeweils mindestens einen Zentriergeometrie vorgesehen ist, wobei der mindestens eine Aufnahmeabschnitt ausgelegt ist, die mindestens eine Zentriergeometrie abnehmbar aufzunehmen, um die Abdeckplatte (106) in Bezug auf die Grundplatte (302) auszurichten.

8. Werkzeuglose Abdeckungsanordnung (102) nach Anspruch 7, wobei die mindestens eine Zentriergeometrie einen ersten Vorsprung (220, 222) und einen zweiten Vorsprung (224, 226) umfasst, der den ersten Vorsprung (220, 222) schneidet.

9. Werkzeuglose Abdeckungsanordnung (102) nach Anspruch 8, wobei der erste Vorsprung (220, 222) den zweiten Vorsprung (224, 226) perpendikular schneidet.

10. Werkzeuglose Abdeckungsanordnung (102) nach Anspruch 7, wobei:
die mindestens eine Zentriergeometrie eine Vielzahl von Zentriergeometrien (216, 218) umfasst, wobei jede der Vielzahl von Zentriergeometrien (216, 218) in Bezug zueinander beabstandet angeordnet ist; und
der mindestens eine Aufnahmeabschnitt eine Vielzahl von Aufnahmeabschnitten (322, 324) umfasst, wobei jeder der Vielzahl von Aufnahmeabschnitten (322, 324) beabstandet in Bezug zueinander und in Zuordnung zu jeder der Vielzahl von Zentriergeometrien (216, 218) angeordnet ist.

11. Werkzeuglose Abdeckungsanordnung (102) nach Anspruch 7, wobei eine Abmessung von mindestens einer der Vielzahl von Zentriergeometrien (216, 218) in Bezug auf die übrigen der Vielzahl von Zentriergeometrien (216, 218) unterschiedlich ist.

12. Werkzeuglose Abdeckungsanordnung (102) nach Anspruch 1-11, ferner umfassend:
eine erste Verstärkungsrippe (228), die sich zumindest teilweise entlang einer Innenfläche der Abdeckplatte (106) erstreckt; und
eine zweite Verstärkungsrippe (326), die sich zumindest teilweise entlang einer Oberfläche (320) der Grundplatte (302) und in Verbindung mit der ersten Verstärkungsrippe (228) erstreckt,
wobei die erste Verstärkungsrippe (228) und die zweite Verstärkungsrippe (326) so ausgelegt sind, dass sie in einer zusammengesetzten Position der Abdeckplatte (106) in Bezug auf die Grundplatte (302) nebeneinander angeordnet sind.

13. Werkzeuglose Abdeckungsanordnung (102) nach Anspruch 1-12, wobei die Abdeckplatte (106) einen gerippten Vorsprung (234) aufweist, der sich von ihrer Innenfläche aus erstreckt, wobei der gerippte Vorsprung (234) in Verbindung mit der in der Grundplatte (302) vorgesehenen Aussparung (306) vorgesehen ist, wobei der gerippte Vorsprung (234) dazu geeignet ist, ein oder mehrere Kabel abnehmbar aufzunehmen.

14. Werkzeuglose Abdeckungsanordnung (102) nach Anspruch 1-13, wobei die Grundplatte (302) und die Abdeckungsplatte (106) jeweils eine Kante (238, 332) aufweisen, wobei die Kanten (238, 332) so ausgelegt sind, dass sie sich in einer zusammengesetzten Position der Abdeckungsplatte (106) in Bezug auf die Grundplatte (302) zumindest teilweise gegenseitig berühren.

15. Werkzeuglose Abdeckungsanordnung (102) nach Anspruch 1-14, wobei die Vorrichtung (100) eine Ventilsteuereinheit ist.

## Revendications

1. Ensemble couvercle sans outils (102) pour un dispositif électrique ou électronique (100), l'ensemble couvercle sans outils (102) comprenant :
une plaque de base (302) ;
une portion de base (104) apte à recevoir la plaque de base (302) et apte à renfermer un plusieurs éléments ;
une plaque de couverture (106) apte à être fixée de manière amovible à la plaque de base (302) ;
une entaille (306) fournie dans la plaque de base (302) et en association avec la plaque de couverture (106), l'entaille (306) apte à fournir un évidement (114) entre la plaque de base (302) et la plaque de couverture (106) dans une position assemblée ;
**caractérisé en ce que** :
une périphérie (240) de la plaque de couverture (106) s'étend au-dessus d'une périphérie (304) de la plaque de base (302), de sorte que la plaque de couverture (106) peut être soulevée en entrant en contact avec une portion (112) de la plaque de couverture (106) par un utilisateur ;
dans lequel la plaque de couverture (106) inclut un ou plusieurs indicateurs visuels (110).

2. Ensemble de couverture sans outils (102) de la revendication 1, dans lequel l'évidement (114) est apte à recevoir un ou plusieurs doigts de l'utilisateur.

3. Ensemble de couverture sans outils (102) de la revendication 1 et 2, comprenant en outre :
au moins une languette de verrouillage s'étendant loin d'au moins l'une de la plaque de couverture (106) et la plaque de base (302) ; et
au moins une portion de réception de languette fournie sur au moins l'une de la plaque de base (302) et la plaque de couverture (106) et en association avec l'au moins une languette de verrouillage respectivement, dans lequel l'au moins une portion de réception de languette est apte à recevoir de manière amovible l'au moins une languette de verrouillage en son sein pour fixer de manière amovible la plaque de couverture (106) par rapport à la plaque de base (302).

4. Ensemble de couverture sans outils (102) de la revendication 1-3, dans lequel :
l'au moins une languette de verrouillage inclut une pluralité de languettes de verrouillage (204, 206, 208, 210, 212, 214), chacune de la pluralité de languettes de verrouillage (204, 206, 208, 210, 212, 214) disposée espacée par rapport aux autres ; et
l'au moins une portion de réception de languette inclut une pluralité de portions de réception de languette (308, 310, 312, 314, 316, 318), chacune de la pluralité de portions de réception de languette (308, 310, 312, 314, 316, 318) disposée espacée par rapport aux autres et en association par rapport à chacune de la pluralité de languettes de verrouillage (204, 206, 208, 210, 212, 214).

5. Ensemble de couverture sans outils (102) de la revendication 4, dans lequel l'au moins une languette de verrouillage inclut une portion élargie (406, 408) sur une extrémité distale de celle-ci, la portion élargie (406, 408) apte à être encliquetée sur au moins une portion de réception de languette.

6. Ensemble de couverture sans outils (102) de la revendication 4 et 5, dans lequel une hauteur (H) de l'au moins une languette de verrouillage est égale à une hauteur totale (HC) de la plaque de couverture (106).

7. Ensemble de couverture sans outils (102) de la revendication 1 comprenant en outre :
au moins une géométrie de centrage s'étendant loin d'au moins l'une de la plaque de couverture (106) et la plaque de base (302) ; et
au moins une portion de réception fournie sur au moins l'une de la plaque de base (302) et la plaque de couverture (106) et en association avec l'au moins une géométrie de centrage respectivement, dans lequel l'au moins une portion de réception est apte à recevoir de manière amovible l'au moins une géométrie de centrage en son sein pour aligner la plaque de couverture (106) par rapport à la plaque de base (302).

8. Ensemble de couverture sans outils (102) de la revendication 7, dans lequel l'au moins une géométrie de centrage inclut une première saillie (220, 222) et une deuxième saillie (224, 226) croisant la première saillie (220, 222).

9. Ensemble de couverture sans outils (102) de la revendication 8, dans lequel la première saillie (220, 222) croise la deuxième saillie (224, 226) perpendiculairement.

10. Ensemble de couverture sans outils (102) de la revendication 7, dans lequel :
l'au moins une géométrie de centrage inclut une pluralité de géométries de centrage (216, 218), dans lequel chacune de la pluralité de géométries de centrage (216, 218) est disposée espacée par rapport aux autres ; et
l'au moins une portion de réception inclut une pluralité de portions de réception (322, 324), dans lequel chacune de la pluralité de portions de réception (322, 324) est disposée espacée par rapport aux autres et en association par rapport à chacune de la pluralité de géométries de centrage (216, 218).

11. Ensemble de couverture sans outils (102) de la revendication 7, dans lequel une dimension d'au moins une de la pluralité de géométries de centrage (216, 218) est différentes par rapport au reste de la pluralité de géométries de centrage (216, 218).

12. Ensemble de couverture sans outils (102) de la revendication 1-11 comprenant en outre :
une première nervure de renforcement (228) s'étendant, au moins partiellement, le long d'une surface interne de la plaque de couverture (106) ; et
une deuxième nervure de renforcement (326) s'étendant, au moins partiellement, le long d'une surface (320) de la plaque de base (302) et en association avec la première nervure de renforcement (228),
dans lequel la première nervure de renforcement (228) et la deuxième nervure de renforcement (326) sont aptes à être positionnées l'une à côté de l'autre dans une position assemblée de la plaque de couverture (106) par rapport à la plaque de base (302).

13. Ensemble de couverture sans outils (102) de la revendication 1-12, dans lequel la plaque de couverture (106) inclut une saillie rainurée (234) s'étendant d'une surface interne de celle-ci, la saillie rainurée (234) fournie en association avec l'entaille (306) fournie dans la plaque de base (302), la saillie rainurée (234) apte à recevoir de manière amovible un ou plusieurs câbles en son sein.

14. Ensemble de couverture sans outils (102) de la revendication 1-13, dans lequel chacune de la plaque de base (302) et la plaque de couverture (106) inclut un bord (238, 332) de celle-ci, les bords (238, 332) aptes, au moins partiellement, à entrer en contact l'un avec l'autre dans une position assemblée de la plaque de couverture (106) par rapport à la plaque de base(302).

15. Ensemble de couverture sans outils (102) de la revendication 1-14, dans lequel le dispositif (100) est une unité de contrôle de vanne.
